(19) Europäisches Patentamt
European Patent Office
Office européen des brevets

(11) **EP 4 708 904 A1**

(12) **EUROPEAN PATENT APPLICATION**
published in accordance with Art. 153(4) EPC

(43) Date of publication:
**11.03.2026 Bulletin 2026/11**

(21) Application number: **23962961.1**

(22) Date of filing: **29.12.2023**

(51) International Patent Classification (IPC):
***H04R 1/10*** *(2026.01)*

(52) Cooperative Patent Classification (CPC):
**H04R 1/10**

(86) International application number:
**PCT/CN2023/143682**

(87) International publication number:
**WO 2025/138288 (03.07.2025 Gazette 2025/27)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Shenzhen Shokz Co., Ltd.
Shenzhen, Guangdong 518108 (CN)**

(72) Inventors:
• **ZHOU, Wenbing
Shenzhen, Guangdong 518108 (CN)**

• **HUANG, Yujia
Shenzhen, Guangdong 518108 (CN)**
• **KE, Hao
Shenzhen, Guangdong 518108 (CN)**
• **ZHANG, Henghao
Shenzhen, Guangdong 518108 (CN)**
• **LIAO, Fengyun
Shenzhen, Guangdong 518108 (CN)**
• **QI, Xin
Shenzhen, Guangdong 518108 (CN)**

(74) Representative: **Wang, Bo
Panovision IP
Ebersberger Straße 3
85570 Markt Schwaben (DE)**

(54) **ACOUSTIC DEVICE**

(57)     An acoustic device is provided. The acoustic device includes a housing, a waterproof assembly, an acoustic assembly, a fixing assembly, and a sealing member. The housing includes an outer wall, an inner wall, an accommodation cavity, and a sound connection hole. The sound connection hole opens into the accommodation cavity and penetrates through the housing for connecting the accommodation cavity to an external space of the housing, and the sound connection hole includes a first opening on the outer wall and a second opening on the inner wall. The waterproof assembly is disposed within the accommodation cavity and covers the sound connection hole to prevent liquid from entering an internal space of the housing from the external space of the housing. The acoustic assembly includes an acoustic transducer. The acoustic assembly is disposed on a side of the waterproof assembly away from the sound connection hole and forms a first gap with the inner wall. The fixing assembly is disposed on the inner wall for fixing the acoustic assembly and the waterproof assembly in the internal space. The sealing member is configured to seal the first gap.

FIG. 2A

## Description

### TECHNICAL FIELD

The present disclosure relates to the technical field of electronic devices, and specifically relates to acoustic devices.

### BACKGROUND

A housing of an acoustic device is typically provided with a sound connection hole, which is used to transmit sound from an external environment to an interior of the acoustic device or transmit the sound from the interior of the acoustic device to the external environment. When the acoustic device is used outdoors or in humid environments, liquids (e.g., water) may easily enter the acoustic device through the sound connection hole formed in the housing. For example, to collect ambient sound and ensure call quality, a microphone of a wireless earphone is typically provided with a sound connection hole for air conduction sound transmission. When a user wears the wireless earphone underwater (e.g., during swimming), the water may enter an interior of the wireless earphone through the sound connection hole. Once moisture penetrates into the wireless earphone, it may cause malfunction of internal components of the wireless earphone (e.g., the microphone or a speaker may fail), and short circuits may occur in a main board or some components, resulting in an inability of the user to normally use the wireless earphone.

Therefore, certain measures need to be adopted to improve the waterproofing performance of existing acoustic devices, particularly to enhance the waterproofing protection for components such as the microphone, the speaker, etc.

### SUMMARY

The present disclosure provides an acoustic device. The acoustic device includes a housing, a waterproof assembly, an acoustic assembly, a fixing assembly, and a sealing member. The housing includes an outer wall, an inner wall, an accommodation cavity, and a sound connection hole. The sound connection hole opens into the accommodation cavity and penetrates through the housing for connecting the accommodation cavity to an external space of the housing, and the sound connection hole includes a first opening on the outer wall and a second opening on the inner wall. The waterproof assembly is disposed within the accommodation cavity and covers the sound connection hole to prevent liquid from entering an internal space of the housing from the external space of the housing. The acoustic assembly includes an acoustic transducer. The acoustic assembly is disposed on a side of the waterproof assembly away from the sound connection hole and forms a first gap with the inner wall. The fixing assembly is disposed on the inner wall for fixing the acoustic assembly and the waterproof assembly in the internal space. The sealing member is configured to seal the first gap.

In some embodiments, the acoustic assembly further includes a circuit board, and the circuit board is provided with at least one first fixing hole and mechanically connected to the acoustic transducer; and the fixing assembly includes at least one fixing member, each of the at least one fixing member cooperates with one of the at least one first fixing hole.

In some embodiments, the fixing member includes a rod portion and a head portion, a first end of the rod portion is connected to the inner wall, and a second end of the rod portion is connected to the head portion; the rod portion of the fixing member passes through the corresponding first fixing hole, and the head portion of the fixing member abuts against the circuit board along a first direction to fix the acoustic assembly and the waterproof assembly in the internal space, the first direction being perpendicular to an upper surface of the circuit board.

In some embodiments, the acoustic assembly further includes a reinforcing member, the reinforcing member is disposed between the circuit board and the waterproof assembly, and the reinforcing member includes at least one second fixing hole; and the rod portion of each of the at least one fixing member passes through one second fixing hole among the at least one second fixing hole.

In some embodiments, the acoustic assembly further includes a circuit board and a reinforcing member, the reinforcing member is disposed between the waterproof assembly and the circuit board, and mechanically connected to the circuit board; and the reinforcing member is provided with at least one third fixing hole, the fixing assembly includes at least one fixing member, and each of the at least one fixing member cooperates with each of the at least one third fixing hole.

In some embodiments, the circuit board is a flexible circuit board; the reinforcing member is in a form of a plate, and a stiffness of the reinforcing member is greater than a stiffness of the circuit board.

In some embodiments, the inner wall is a curved surface, the inner wall further includes an assembly groove, the accommodation cavity is disposed in the assembly groove, a bottom surface of the assembly groove is a plane, at least a portion of the circuit board is mounted within the assembly groove and abuts against the bottom surface of the assembly groove, a shape of the assembly groove matches the circuit board or the reinforcing member to restrict a movement of the acoustic assembly in an extension direction of a board surface of the circuit board.

In some embodiments, the at least one fixing member includes a screw and/or a heat stake; and the at least one fixing member is distributed around the accommodation cavity.

In some embodiments, a thickness of the waterproof assembly in a free state is greater than a depth of the accommodation cavity.

In some embodiments, the waterproof assembly includes: a waterproof membrane; and a buffer member provided with a center hole, the buffer member abutting against an edge region of the waterproof membrane.

In some embodiments, the waterproof assembly has a first bonding surface and a second bonding surface; the first bonding surface includes an adhesive configured to bond the waterproof assembly to an accommodation bottom wall of the accommodation cavity when an external pressure is applied to the first bonding surface; and the second bonding surface includes an adhesive configured to bond the waterproof assembly to the acoustic assembly when the second bonding surface contacts the acoustic assembly.

In some embodiments, the acoustic device is an earphone, and the acoustic transducer is a microphone and/or a speaker.

In some embodiments, the sealing member is obtained by providing a fluid sealing material to the first gap and then curing the fluid sealing material.

In some embodiments, the fluid sealing material is a sealant.

In some embodiments, the waterproof assembly is disposed on an accommodation bottom wall of the accommodation cavity, and a center axis of the sound connection hole is inclined relative to the accommodation bottom wall; the second opening is smaller than the first opening; and an average diameter of the sound connection hole is in a range of 0.6 millimeters (mm)-1.2mm.

In some embodiments, the acoustic transducer includes a first acoustic transducer and a second acoustic transducer; the accommodation cavity includes a first accommodation cavity and a second accommodation cavity that accommodates the first acoustic transducer and the second acoustic transducer, respectively.

According to some embodiments of the present disclosure, the acoustic device is provided with the waterproof assembly at the sound connection hole, thereby preventing the liquid from flowing into the acoustic assembly, and ensuring the waterproofing capability of the acoustic device. Moreover, by disposing the fixing assembly in the acoustic device, the waterproof assembly and the acoustic assembly can be fixed in the interior of the housing, thereby further preventing the liquid from flowing into the interior of the housing, and improving the waterproofing capability of the acoustic device.

Other functions of the acoustic device provided in the present disclosure are listed in the following description. Creative aspects of the acoustic device provided in the present disclosure can be fully explained by practice or using methods, devices, and combinations described in the detailed examples below.

## BRIEF DESCRIPTION OF THE DRAWINGS

In order to more clearly illustrate the technical solutions in the embodiments of the present disclosure, the accompanying drawings that need to be used in the description of the embodiments will be briefly introduced in the following. Obviously, the drawings in the following description are only some of the embodiments of the present disclosure, and for a person skilled in the art, other drawings can be obtained according to these drawings without creative labor.

FIG. 1 is a schematic diagram illustrating a structure of an acoustic device according to some embodiments of the present disclosure;

FIG. 2A is an A-A sectional view of the acoustic device of FIG. 1 according to some embodiments of the present disclosure;

FIG. 2B is a schematic diagram illustrating an accommodation cavity according to some embodiments of the present disclosure;

FIG. 3 is a schematic diagram illustrating structures of various parts of an acoustic device according to some embodiments of the present disclosure;

FIG. 4 is a schematic diagram illustrating a structure of an acoustic assembly including two acoustic transducers according to some embodiments of the present disclosure;

FIG. 5A is a schematic diagram illustrating a structure of an acoustic device according to embodiments of the present disclosure;

FIG. 5B is a schematic diagram illustrating a structure of another acoustic device according to embodiments of the present disclosure;

FIG. 5C is a schematic diagram illustrating a structure of another acoustic device according to some embodiments of the present disclosure;

FIG. 6A is a schematic diagram illustrating a shape of a heat stake before heat staking according to some embodiments of the present disclosure; and

FIG. 6B is a schematic diagram illustrating a shape of the heat stake shown in FIG. 6A after the heat staking according to some embodiments of the present disclosure.

## DETAILED DESCRIPTION

The following description provides specific application scenarios and requirements of the present disclosure, with the purpose of enabling those skilled in the art to manufacture and use the contents of the present disclosure. Various modifications to the disclosed embodiments will be readily apparent to those skilled in the art, and the general principles defined herein may be applied to other embodiments and applications without departing from the spirit and scope of the present disclosure. Thus, the present disclosure is not limited to the embodiments shown, but to be accorded the widest scope consistent with the claims.

The terminology used herein is for the purpose of describing particular example embodiments only and is not intended to be limiting. As used herein, the singular forms "a," "an," and "the" may be intended to include the plural forms as well, unless the context clearly indicates otherwise. It will be further understood that the terms "comprising," "including," and/or "containing," when used in this specification, specify the presence of associated integers, steps, operations, elements, and/or components, but do not preclude the presence or addition of one or more other features, integers, steps, operations, elements, components, and/or groups thereof.

In this application, the terms "top," "bottom," "left ", "right," "front," "rear," "top," "bottom," "inside," "outside," "vertical," "horizontal," "lateral," "longitudinal," etc., indicate orientation or positional relationships based on orientation or positional relationships shown in the accompanying drawings. These terms are primarily intended to better describe the present disclosure and the embodiments, and are not intended to specify that the indicated devices, elements, or components must have particular orientations, or be constructed and operated in the particular orientations.

Moreover, some of the above terms may be used to indicate other meanings in addition to the orientation or positional relationship, for example, the term "on" may also be used to indicate a certain dependency or connection in some instances. The specific meanings of these terms in the present disclosure may be understood in context to those skilled in the art.

In addition, the terms "install," "dispose," "have," "connect," and "link" are to be understood broadly. For example, the terms include a fixed connection, a removable connection, or an integral construction. As another example, the terms include a mechanical connection or an electrical connection. As still another example, the terms include a direct connection or an indirect connection through an intermediate medium, or an internal connection between two devices, elements, or components. To those skilled in the art, the specific meaning of the above terms in the present disclosure may be understood on a case-by-case basis.

In the present disclosure, "X includes at least one of A, B, or C" means that X at least includes A, or X at least includes B, or X at least includes C. That is, X may include any one of A, B, or C, or any combination of A, B, and C, as well as other possible contents/elements. The any combination of the A, B, C may be A, B, C, AB, AC, BC, or ABC.

In the present disclosure, unless explicitly stated, the associative relationship arising between the structures may be a direct associative relationship or an indirect associative relationship. For example, when describing "A is connected to B," unless it is explicitly stated that A is directly connected to B, it should be understood that A is directly connected to B, or indirectly connected to B. As another example, when describing "A is above B," unless it is explicitly stated that A is directly above B (A and B are adjacent to each other and A is above B), it should be understood that A is directly above B, or indirectly above B (A and B are separated from other elements, and A is above B), and so on.

These and other features of the present disclosure, as well as operations and functions of the related elements of the structure and the combination of parts and economies of manufacture, may become more apparent upon consideration of the following description with reference to the accompanying drawings, all of which form a part of the present disclosure. It is to be expressly understood, however, that the drawings are for the purpose of illustration and description only and are not intended to limit the scope of the present disclosure.

The following descriptions may significantly improve these and other features of the present disclosure, as well as the operations and functions of the related elements of the structure and the combination of parts and economies of manufacture. Referring to the accompanying drawings, all these features form a part of the present disclosure. It is to be expressly understood, however, that the drawings are for the purpose of illustration and description only and are not intended to limit the scope of the present disclosure. It is understood that the drawings are not to scale.

The present disclosure is described in detail below by way of specific embodiments.

A housing of an acoustic device is typically provided with a sound connection hole, which is used to transmit sound from an external environment to an interior of the acoustic device or transmit the sound from the interior of the acoustic device to the external environment. For example, to ensure call quality, a wireless earphone with a call function is provided with a sound connection hole for a microphone to pick up sound to receive the sound transmitted through the air. To avoid liquids (e.g., water) from entering the acoustic device after the acoustic device is applied in outdoors or in humid environments, and ensure that the acoustic device operates normally, the sound connection hole of the acoustic device needs to be waterproofed. The present disclosure provides the acoustic device. By performing waterproof processing on the sound connection hole, and fixing the acoustic assembly and the waterproof assembly through the fixing assembly, the liquids can be better prevented from flowing into the interior of the housing, thereby improving the waterproofing capability of the acoustic device. The liquids in the present disclosure include water, oil, sweat, or the like, or any combination thereof, and for the convenience of description, water is taked as an example below.

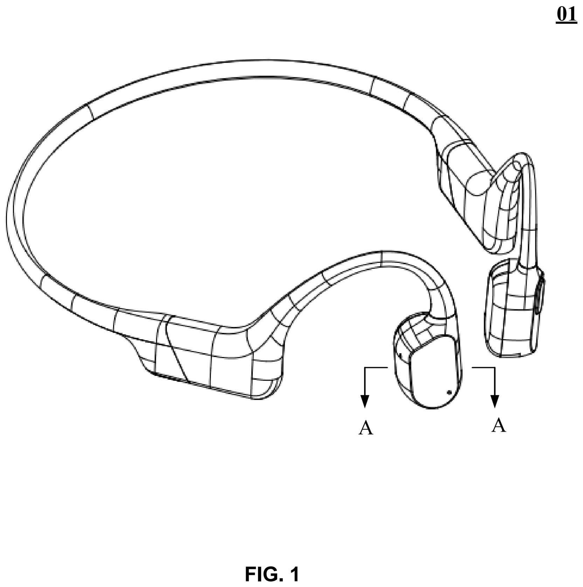

FIG. 1 is a schematic diagram illustrating a structure of an acoustic device 01 according to some embodiments of the present disclosure. The acoustic device 01 illustrated in FIG. 1 is an earphone (e.g., a wireless earphone). The acoustic device 01 being the (wireless) earphone is taken as an example and described below. The (wireless) earphone may be a bone conduction earphone, an air conduction earphone, or a bone-air conduction earphone. It can be noted that the acoustic device 01 may also be other acoustic devices, such as, a mobile phones, a computer, a recorder, etc.

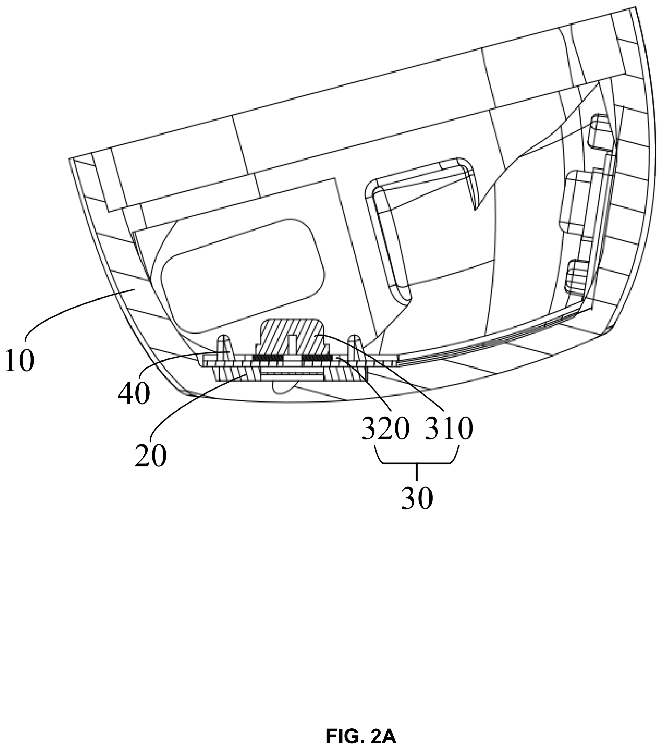

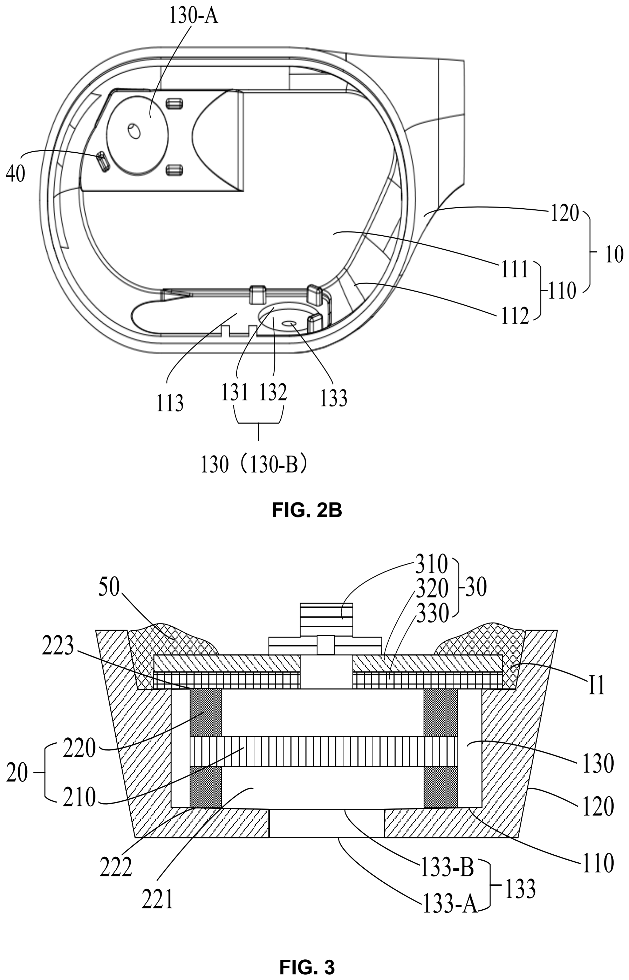

FIG. 2A is an A-A sectional view of the acoustic device 01 of FIG. 1 according to some embodiments of the present disclosure. FIG. 2B is a schematic diagram illustrating an accommodation cavity 130 according to some embodiments of the present disclosure. As shown in FIG. 2A, the acoustic device 01 may include a housing 10, a waterproof assembly 20, an acoustic assembly 30, a fixing assembly 40, and a sealing member 50 (not shown in FIG. 2A or FIG. 2B).

As shown in FIG. 2B, the housing 10 may be a mounting assembly of the acoustic device 01. Other parts (e.g., the waterproof assembly 20, the acoustic assembly 30, the fixing assembly 40, etc.) of the acoustic device 01 may be mounted with the housing 10 as a carrier. The housing 10 may include an inner wall 110, and an outer wall 120. The outer wall 120 may be an exterior surface of the acoustic device 01 ultimately presented to a user. The outer wall 120 may be a smooth curved surface. The inner wall 110 may be provided with a groove or a protrusion to facilitate assembly. The inner wall 110 of the housing 10 may include a housing bottom wall 111 and a housing sidewall 112. The housing bottom wall 111 and the housing sidewall 112 enclose to form an internal space, the other parts of the acoustic device 01 are disposed in the internal space. The fixing assembly 40 may be disposed on the inner wall 110. In some embodiments, the inner wall 110 may be a curved surface, and the inner wall 110 may also include an assembly groove 113.

The shape of the housing 10 may be any shape, for example, a runway shape (a rounded rectangle) or a circle. In some embodiments, the housing 10 may include two parts. After the other parts are assembled, the two parts are snapped to form an appearance of the acoustic device 01 as seen by the user. The shape of the housing 10 may be any shape. For example, when the acoustic device 01 is a wireless earphone, the housing 10 is a shape that conforms to a contour of a human ear, thereby allowing the wireless earphone to be securely worn on the user's ear. A material of the housing 10 may be any material, such as, metal, plastic, polymer, etc. The present disclosure does not limit the shape and the material of the housing 10.

The housing 10 may include the accommodation cavity 130. The accommodation cavity 130 is used to accommodate other parts, such as, the waterproof assembly 20. In some embodiments, the inner wall 110 of the housing 10 may form an accommodation sidewall 131 and an accommodation bottom wall 132 of the accommodation cavity 130. For example, the housing bottom wall 111 or the housing sidewall 112 of the housing 10 may form the accommodation bottom wall 132 and the accommodation sidewall 131. Alternatively, the housing bottom wall 111 forms the accommodation bottom wall 132 and a portion of the accommodation sidewall 131, and the housing sidewall 112 forms another portion of the accommodation sidewall 131. In some embodiments, the accommodation cavity 130 is a space enclosed by other parts. As shown in FIG. 2B, the accommodation cavity 130 may also be within the assembly groove 113.

The accommodation cavity 130 may be provided with a sound connection hole 133 penetrating through the housing 10. For example, the sound connection hole 133 may be provided in the accommodation bottom wall 132 of the accommodation cavity 130. The sound connection hole 133 allows sound waves to pass through. External sound waves may enter the housing 10 through the sound connection hole 133 and be collected by the acoustic assembly 30. The sound waves generated by the acoustic assembly 30 may also be transmitted to the outside through the sound connection hole 133. Due to a sectioning position, the complete structure of the sound connection hole 133 is not shown in FIG. 2 A. Merely by way of example, FIG. 3 is a schematic diagram illustrating structures of various parts of an acoustic device 01 according to some embodiments of the present disclosure. As may be seen from FIG. 3, the sound connection hole 133 penetrates through the housing 10. The sound connection hole 133 may include a first opening 133-A in the outer wall 120 and a second opening 133-B in the inner wall 110.

In some embodiments, the second opening 133-B is smaller than the first opening 133-A. That is, the sound connection hole 133 may be in a shape of a horn with a larger outer diameter and a smaller inner diameter. By designing the sound connection hole 133 in the shape of the horn, a foreign matter (e.g., solids or liquids) that enters the sound connection hole 133 can be easily cleaned by the user, and a mold can be withdrawn smoothly during a process of the sound connection hole 133. A shape of the sound connection hole 133 may be any shape, such as, a circle, an oval, a square, a rectangle, etc., and the present disclosure does not limit the shape of the sound connection hole 133.

In some embodiments, a center axis of the sound connection hole 133 may be inclined relative to the accommodation bottom wall 132, thereby preventing water from entering into the interior of the housing 10 through the sound connection hole 133. The center axis of the sound connection hole 133 may be a line connecting a center of the first opening 133-A in the outer wall 120 of the sound connection hole 133 and a center of the second opening 133-B in the inner wall 110. An angle of the center axis of the sound connection hole 133 inclined relative to the accommodation bottom wall 132 may be selected according to design and processing requirements of a product (e.g., the acoustic device 01) without affecting an acoustic performance of the acoustic device 01. In some embodiments, a value of the inclined angle may be within an interval of [30, 90) degrees. When the inclined angle is within an interval of [60, 90) degrees, a difficulty of processing the sound connection hole 133 is reduced while ensuring a certain inclined degree. When the inclined angle is within an interval of [30, 60] degrees, an obstruction capability of water entering the interior of the housing 10 through the sound connection hole 133 can be further improved. In some application scenarios, such as swimming, by inclining the sound connection hole 133, the water flow does not directly surge into the sound connection hole 133 when a dynamic water pressure is applied to the acoustic device 01, thereby improving a waterproofing capability of the acoustic device 01 under the dynamic water pressure. In some embodiments, the center axis of the sound connection hole 133 may be disposed vertically relative to the accommodation bottom wall 132. That is, an angle between the center axis and the accommodation bottom wall 132 is 90 degrees, thereby reducing the processing difficulty of the sound connection hole 133. The shape of the sound connection hole 133 may be any shape, such as, a circle, an oval, a square, a rectangle, etc., and the present disclosure does not limit the shape of the sound connection hole 133.

In some embodiments, the sound connection hole 133 is a clearance hole. That is, a sound guiding path of the sound connection hole 133 is bent, so that the whole resembles an "L" shape. By defining a bending position as a boundary, a bending angle between the center axis before the bend and the center axis after the bend is not equal to zero. The bending angle may be 90 degrees, resulting in the "L" shape described above. Alternatively, the bending angle may not be 90 degrees, such as greater than 90 degrees. By designing the sound connection hole 133 as the clearance hole, when the dynamic water pressure is applied to the acoustic device 01, the water flow does not directly surge into the sound connection hole 133 through the bending angle of the sound connection hole 133, thereby improving a dynamic waterproofing capability of the acoustic device 01.

In some embodiments, an average diameter of the sound connection hole 133 is within a range from 0.6 mm to 1.2 mm, thereby reducing the hole diameter to reduce a possibility of the liquids entering the interior of the housing 10 while not affecting a sound pickup of the acoustic device 01. The average diameter refers to an average value of a diameter of the first opening 133-A and a diameter of the second opening 133-B of the sound connection hole 133.

In some embodiments, the sound connection hole 133 has a cylindrical structure. A diameter of a surface of the cylindrical structure cut by any cross-section is within a range from 0.6 mm to 1.2 mm. The cross-section is perpendicular to the center axis of the sound connection hole 133. In some embodiments, the sound connection hole 133 has a frustum structure. A diameter of a surface of the frustum structure cut by any cross-section is within a range from 0.6 mm to 1.2 mm. The cross-section is perpendicular to the center axis of the sound connection hole 133.

In some embodiments, the acoustic device 01 includes a plurality of accommodation cavities 130 to accommodate a plurality of parts, respectively. For example, as shown in FIG. 2B, the accommodation cavity 130 may include a first accommodation cavity 130-A and a second accommodation cavity 130-B. The first accommodation cavity 130-A may be disposed on the housing bottom wall 111, and the second accommodation cavity 130-B may be disposed on the housing sidewall 112, so that the sound connection holes 133 in the different accommodation cavities 130 receive the sound in different directions or transmit the sound in different directions. In some embodiments, both the first accommodation cavity 130-A and the second accommodation cavity 130-B are disposed on either the housing bottom wall 111 or the housing sidewall 112, thereby improving an ability for the sound connection holes 133 to receive the sound in the same direction or transmit the sound in the same direction. The first accommodation cavity 130-A and the second accommodation cavity 130-B may accommodate different components, respectively. The specific contents will be described below.

In some embodiments, the acoustic device 01 may include a sealing member 50. The sealing member 50 may seal assembly gaps between various parts in the accommodation cavity 130, thereby improving the waterproofness of the acoustic device 01.

Continuing to refer to FIG. 3, the waterproof assembly 20 is disposed inside the accommodation cavity 130 and covers the sound connection hole 133 to prevent the liquids from entering the internal space of the housing 10 from the external space of the housing 10. The acoustic assembly 30 is disposed on a side of the waterproof assembly 20 away from the sound connection hole 133.

In some embodiments, as shown in FIG. 3, the waterproof assembly 20 may include a waterproof membrane 210 and a buffer member 220. The waterproof membrane 210 may allow air molecules to pass through and block water molecules from passing through the waterproof membrane 210. The waterproof membrane 210 may be made of a waterproofing and breathable material with an equivalent microporous structure. A feature of the waterproofing and breathable material is that the air molecules can pass through the equivalent microporous structure and the water molecules can not pass through the equivalent microporous structure. When the acoustic device 01 is operating, and the sound waves propagate to an interface of the waterproof membrane 210, the air molecules, due to a relatively large spacing between the air molecules and a small size of the air molecules, freely pass in and out of the equivalent microporous structure of the waterproof membrane 210. For example, ambient sound waves pass through the waterproof membrane 210 to be collected by a microphone. As another example, the sound waves generated by a speaker pass through the waterproof membrane 210 to the outside of the acoustic device 01.

The buffer member 220 may be provided with a center hole 221, and the buffer member 220 may abut against an edge of the waterproof membrane 210. Specifically, a non-perforated edge region of the buffer member 220 abuts against the edge of the waterproof membrane 210. Specifically, the edge region of the buffer member 220 may abut against the edge region of the waterproof membrane 210. That is, the waterproof membrane 210 may completely cover the center hole 221 of the buffer member 220, so that the liquid flowing through the center hole 221 is blocked by the waterproof membrane 210.

In some embodiments, the center hole 221 and the second opening 133-B of the sound connection hole 133 are not coaxial. In some embodiments, the center hole 221 and the second opening 133-B of the sound connection hole 133 are coaxial, so that the water pressure of the water flowing from the sound connection hole 133 is uniformly applied to the waterproof membrane 210. This prevents the waterproof membrane 210 from being damaged due to uneven water pressure, which could otherwise reduce or even compromise the effectiveness of the waterproof assembly 20. The center hole 221 and the second opening 133-B being coaxial refers to that a center axis of the center hole 221 coincides with a center axis of the second opening 133-B.

A shape of the center hole 221 may be any shape, such as, a circle, an oval, a square, a rectangle, etc., and the present disclosure does not limit the shape of the center hole 221. In some embodiments, the shape of the center hole 221 is adapted to the shape of the sound connection hole 133, and a hole diameter of the center hole 221 is larger than a hole diameter of the sound connection hole 133, so that a relatively large region of the waterproof membrane 210 can transmit the sound, thereby reducing an acoustic loss. The hole diameter refers to a diameter of the corresponding hole. In some embodiments, the hole diameter of the center hole 221 is within a range from 0.8 mm to 1.8 mm. The hole diameter of the center hole 221 can be increased to enlarge an area of the waterproof membrane 210 that the water pressure is applied to while adapted to the accommodation space of the accommodation cavity 130 and the hole diameter of the sound connection hole 133. In some embodiments, the hole diameter of the sound connection hole 133 is within the range from 0.6mm to 1.2mm as described above. The hole diameter of the sound connection hole 133 can be reduced to reduce the possibility of the liquids entering the interior of the housing 10 while not affecting the sound pickup of the acoustic device 01.

In some embodiments, the waterproof assembly 20 may have a bonding surface, so that the waterproof assembly 20, after placed in the accommodation cavity 130, is bonded to the accommodation bottom wall 132 of the accommodation cavity 130 by the bonding surface, thereby realizing a sealing connection and fixing the waterproof assembly 20. For example, the waterproof assembly 20 may have a first bonding surface 222 and a second bonding surface 223. The first bonding surface 222 may bond the waterproof assembly 20 within the accommodation cavity 130 after an external pressure is applied to the first bonding surface 222. For example, the external pressure is provided by gravity of the acoustic assembly 30, or provided by a manual direct contact with the waterproof assembly 20. In some embodiments, the external pressure is also applied to the waterproof assembly 20 through a pressure jig.

The second bonding surface 223 may seal and bond the waterproof assembly 20 and the acoustic assembly 30 when the waterproof assembly 20 and the acoustic assembly 30 contact. Specifically, the waterproof assembly 20 may have two buffer members 220 disposed on two sides of the waterproof membrane 210, respectively. Two surfaces of the buffer members 220 facing the accommodation cavity 130 and the acoustic assembly 30 may have viscosity. After the waterproof assembly 20 is placed in the accommodation cavity 130, a preset pressure is applied on the waterproof assembly 20 under the external pressure, so that the waterproof assembly 20 is firmly bonded to the accommodation bottom wall 132. By providing the bonding surfaces, the waterproof assembly 20 is fixed in the accommodation cavity 130 by means of bonding, thereby realizing the waterproof effect and ensuring the simplicity and convenience of the operation process.

Furthermore, the buffer members 220 may also have elasticity. The buffer members 220 may uniformly distribute a physical pressure (an impact energy) to which the waterproof assembly 20 is subjected. Therefore, during the installation of the waterproof assembly 20, the buffer members 220 may protect the waterproof membrane 210 from being wrinkled due to a great impact, thereby affecting waterproofing and acoustic properties of the waterproof membrane 210. In some embodiments, a material of the buffer members 220 may be a foam adhesive, an acrylic adhesive (an acrylate adhesive), or a combination of the foam and the acrylic adhesive (the acrylate adhesive). In some embodiments, a thickness of one of the buffer members 220 is larger than or equal to 0.1 mm. When the buffer members 220 have a certain thickness, a height/thickness of the waterproof assembly 20 may be increased, thereby making the waterproof assembly 20 easy to install, remove, and assemble into the housing 10. Moreover, when the buffer member 220 has a certain thickness, the deformability of the waterproof assembly 20 can be increased to adapt to manufacturing errors of different housings 10, thereby making the waterproof assembly 20 easier to be assembled into the housing 10.

In some embodiments, the ends of the waterproof membrane 210 are directly connected with support members, and the support members are then connected to the buffer members 220. The support members may reduce a wrinkling degree of the waterproof membrane 210 when the waterproof assembly 20 is assembled. When the waterproof assembly 20 is assembled into the housing 10 of the earphone, the waterproof assembly 20 is subjected to a given pressure from the outside. The pressure may be the gravity of the acoustic assembly 30 or the pressure applied by the pressure jig. The pressure may have a lateral component. That is, the waterproof membrane 210 is subjected to a lateral shearing force. At this time, if the waterproof membrane 210 is subjected to the lateral shearing force alone, the waterproof membrane 210 would wrinkle. Due to a strong resistance to deformation of the support members, the support members hardly deform when subjected to the lateral shearing force. Therefore, the anti-deformation capacity of the waterproof membrane 210 that is supported by the support members is also improved, thereby reducing the wrinkling degree of the waterproof membrane 210 during the assembly. The wrinkling degree of the waterproof membrane may be a height difference between a highest point and a lowest point of the wrinkled waterproof membrane with the waterproof membrane in a flat state as a criterion. The larger the height difference, the greater the wrinkling degree. The smaller the height difference, the smaller the wrinkling degree. In some embodiments, a material of the support members may be polyethylene terephthalate (PET). The PET has a good shearing strength and is able to support the waterproof membrane 10. In some embodiments, a thickness of one of the support members is less than or equal to 0.1 mm, thereby reducing a space occupied inside the housing 10 while ensuring a support strength. In some embodiments, one side of one of the support members is connected to the waterproof membrane 210, and the other side of the support member is connected to the buffer member 220.

In some embodiments, each of the support members and the waterproof membrane 210 are bonded by a bonding layer. In some embodiments, the bonding layer is an acrylic adhesive. The acrylic adhesive has relatively great strength and stiffness. By using the acrylic adhesive to bond the support members and the waterproof membrane 210, the bonding layers are less prone to deformation when the support members and the waterproof membrane 210 are subjected to lateral forces, thereby preventing the deformation of the waterproof membrane 210. To ensure the firmness of the bonding layers, the thickness of each of the bonding layers should not be too small or too great, so as to facilitate the processing of the waterproof assembly 20 and improve the strength of a sandwich structure where the waterproof membrane 210 is sandwiched in the middle of two support members. In some embodiments, the thickness of one of the bonding layers is within a range from 0.03 mm to 0.05 mm.

In some embodiments, the thickness of the waterproof assembly 20 in a free state is larger than a depth of the accommodation cavity 130. That is, a height of the buffer members 220 (the waterproof assembly 20) not compressed by the external force is larger than a height of the accommodation sidewall 131 of the accommodation cavity 130, so that the waterproof assembly 20 can be compressed by the acoustic assembly 30 or other parts after the waterproof assembly 20 is assembled into the accommodation cavity 130.

To reduce a difficulty of assembling the waterproof assembly 20, the acoustic assembly 30, and the accommodation cavity 130, a size of the waterproof assembly 20 and a size of the acoustic assembly 30 may be slightly smaller than a size of the accommodation cavity 130. As shown in FIG. 3, the acoustic assembly 30 may form a first gap l1 with the inner wall 110 of the housing 10. The first gap l1 may be sealed using the sealing member 50. In some embodiments, the sealing member 50 is obtained by providing a fluid sealing material to the first gap l1 and then curing the fluid sealing material. The fluid sealing material may be a sealant. For example, the sealant may be a ultraviolet-ray adhesive (UV adhesive), silicone, a heat staking adhesive, etc. Using a fluidity of the fluid sealing material, the sealing member 50 may not only fill the first gap 11, but also fill the assembly gaps of the various parts, thereby improving the waterproofness of the acoustic device 01.

The acoustic assembly 30 may include an acoustic transducer 310 and a circuit board 320. In some embodiments, the acoustic assembly 30 may be located outside of the accommodation cavity 130, as shown in FIG. 2A. In some embodiments, the acoustic assembly 30 may be at least partially disposed inside the accommodation cavity 130. For example, the circuit board 320 is located inside the accommodation cavity 130, and the acoustic transducer 310 is disposed outside the accommodation cavity 130. The acoustic transducer 310 may receive or emit the sound. Merely by way of example, when the acoustic device 01 is an earphone, the acoustic transducer 310 may includes at least one of a microphone or a speaker.

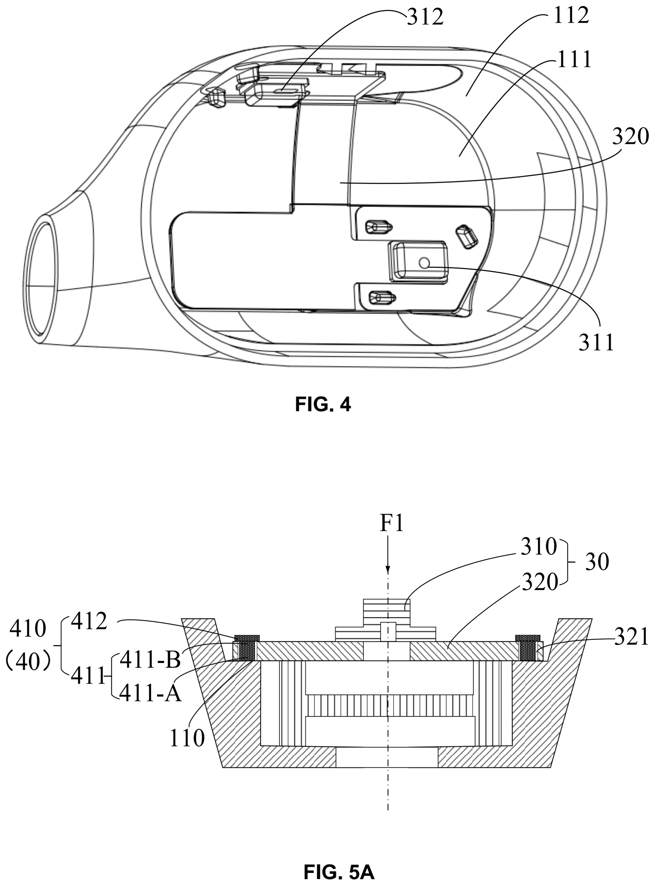

In some embodiments, the acoustic device 01 may include a single acoustic assembly 30. In some embodiments, the acoustic device 01 may also include a plurality of acoustic assemblies 30, thereby including a plurality of acoustic transducers 310 for additional functions. For example, the acoustic device 01 includes two acoustic assemblies 30. Merely by way of example, FIG. 4 is a schematic diagram illustrating a structure of an acoustic device 01 including two acoustic assemblies 30 according to some embodiments of the present disclosure. The acoustic device 01 includes a first acoustic assembly 30-A and a second acoustic assembly 30-B. The first acoustic assembly 30-A includes a first acoustic transducer 311, and the second acoustic assembly 30-B includes a second acoustic transducer 312. For example, when the acoustic transducers 310 are microphones, two microphones are disposed in an earphone to achieve a noise reduction effect. One microphone may be a normal microphone used by the user during a call to collect human voices. The other microphone may be a microphone with a noise collection function, which is convenient to collect noise from a surrounding environment.

In some embodiments, the first acoustic transducer 311 and the second acoustic transducer 312 may be placed on the same circuit board 320. That is, the first acoustic transducer 311 and the second acoustic transducer 312 are connected using one circuit board 320. In some embodiments, the first acoustic transducer 311 and the second acoustic transducer 312 may be placed on different circuit boards 320. The two circuit boards 320 of the two acoustic transducers 310 are then mechanically connected. For example, the two circuit boards 320 of the two acoustic transducers 310 are then connected by other connecting circuit board(s). As another example, the two circuit boards 320 of the two acoustic transducers 310 are electrically connected through board-to-board connector(s) (BTB connector(s)). As further another example, the two circuit boards 320 of the two acoustic transducers 310 are electrically connected to each other via soldering wires. The present disclosure does not limit a manner of the connection of the two acoustic transducers 310. As previously described, the housing 10 may include the first accommodation cavity 130-A and the second accommodation cavity 130-B. The first accommodation cavity 130-A may accommodate the first acoustic transducer 311 and the second accommodation cavity 130-B may accommodate the second acoustic transducer 312.

The acoustic assembly 30 may further include the circuit board 320. The circuit board 320 may be mechanically connected to the acoustic transducer 310. The mechanical connection used herein may be a bonding connection, surface mounting technology (SMT) patching, a soldering connection, a bite-seam connection, a riveting connection, etc. For example, the acoustic transducer 310 is fixed to the circuit board 320 through an SMT patch. The circuit board 320 may be located between the acoustic transducer 310 and the waterproof assembly 20. As previously described, the acoustic assembly 30 may be bonded to the waterproof assembly 20 through the second bonding surface 223 of the buffer member 220. Specifically, the circuit board 320 may connect the acoustic assembly 30 and the waterproof assembly 20 by bonding with the second bonding surface 223 of the buffer member 220. In some embodiments, a pressure may be further applied to the acoustic assembly 30, so that the circuit board 320 is bonded to the second bonding surface 223 more fixedly. For example, the acoustic assembly 30 is pressed down through a pressure jig to apply the pressure to the acoustic assembly 30. As another example, the pressure is applied to the acoustic assembly 30 by placing a heavy object on the acoustic assembly 30.

In some embodiments, the circuit board 320 may be a printed circuit board (PCB). The PCB is not easy to bend and has a certain stiffness, thereby supporting the acoustic transducer 310 well. In some embodiments, the circuit board 320 may be a flexible printed circuit (FPC). The FPC is flexible and may be bent. By bending the FPC, a space occupancy of the housing 10 can be reduced. To increase a local thickness or rigidity of the FPC and ensure a flatness of the FPC, local or overall reinforcement treatment may be performed on the FPC. For example, the FPC may be reinforced by using a steel plate or a polymide (PI) material as a reinforcing member 330. The PI material is an engineering plastic with excellent mechanical properties, and has features, such as, a light weight, a thin thickness, and a good bendability. The reinforcing member 330 may be a reinforcing plate, and a stiffness of the reinforcing member 330 is larger than the stiffness of the circuit board 320. As shown in FIG. 3, the reinforcing member 330 may be located between the circuit board 320 and the waterproof assembly 20, and mechanically connected to the circuit board 320.

In some embodiments, the circuit board 320 may be at least partially located within the accommodation cavity 130. In some embodiments, the circuit board 320 may be also disposed outside the accommodation cavity 130. As shown in FIG. 4, when the circuit board 320 is located outside the accommodation cavity 130, the circuit board 320 may abut against a top surface of the accommodation sidewall 131 of the accommodation cavity 130. As previously described, a bottom surface of the assembly groove 113 is a plane, and the circuit board 320 is at least partially installed within the assembly groove 113 and abuts against a bottom surface of the assembly groove 113. A shape of the assembly groove 113 matches the circuit board 320 or the reinforcing member 330 to limit a movement of the acoustic assembly 30 in an extension direction of a board surface of the circuit board 320.

In some embodiments, the extension direction of the board surface of the circuit board 320 may be designed according to connection requirements. As shown in FIG. 4, the first acoustic transducer 311 and the second acoustic transducer 312 share the same circuit board 320. Therefore, the circuit board 320 connected to the second acoustic transducer 312 extends to the housing bottom wall 111 from the housing sidewall 112, and then connects to the first acoustic transducer 311.

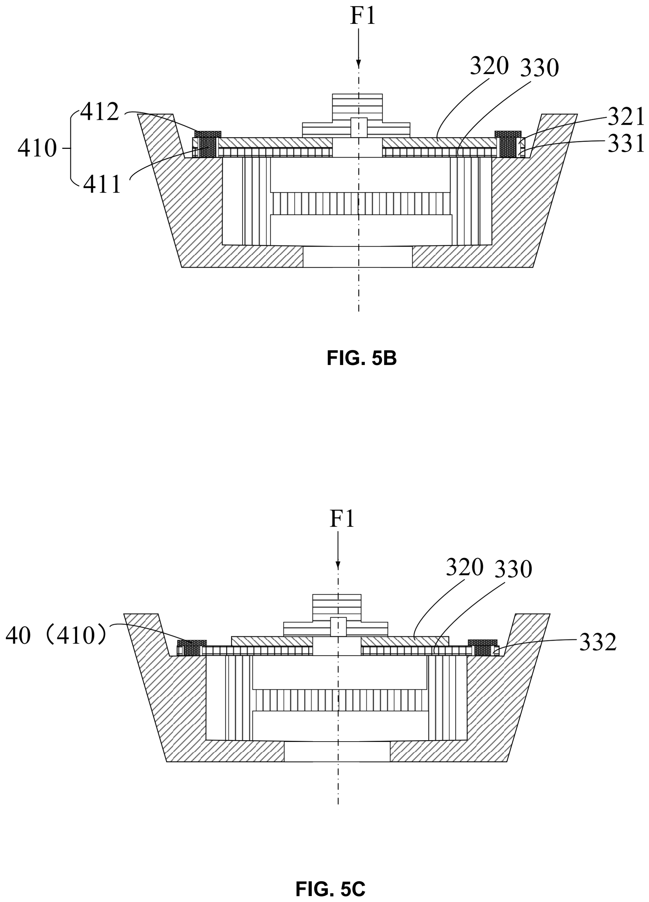

FIG. 5A is a schematic diagram illustrating a structure of an acoustic device 01 according to embodiments of the present disclosure. FIG. 5B is a schematic diagram illustrating a structure of another acoustic device 01 according to embodiments of the present disclosure. FIG. 5C is a schematic diagram illustrating a structure of another acoustic device 01 according to some embodiments of the present disclosure. As previously illustrated, the fixing assembly 40 may be disposed on the inner wall 110.

In some embodiments, the circuit board 320 is provided with at least one first fixing hole 321. The fixing assembly 40 includes at least one fixing member 410. The at least one fixing member 410 and the at least one first fixing hole 321 are matched in a one-to-one corresponding manner, so that the acoustic assembly 30 and the waterproof assembly 320 are fixed in an internal space of the housing 10. In some embodiments, each of the fixing members 410 includes a rod portion 411 and a head portion 412. A first end 411-A of the rod portion 411 connects to the inner wall 110, and a second end 411-B of the rod portion 411 connects to the head portion 412. The head portion 412 of each fixing member 410 abuts against the circuit board 320 along a first direction F1, thereby fixing the acoustic assembly 30 and the waterproof assembly 20 within the internal space. The first direction F1 is perpendicular to an upper surface of the circuit board 320.

As previously described, the buffer members 220 may have the elasticity and be compressed. Moreover, bonding and sealing properties of each of the buffer members 220 relate to a degree (a compression ratio) to which the buffer member 220 is compressed. The buffer member 220 being a foam rubber is taken as an example for illustration. The sealing property of the foam adhesive (i.e., the waterproofing and bonding properties) is positively correlated to a certain extent with the compression ratio of the foam adhesive. That is, the higher the compression of the foam adhesive, the higher the compression ratio, the better the sealing property of the foam adhesive, and the more firmly the bonding. Therefore, by maintaining the compression ratio of the foam adhesive to exceed a preset value, a good and stable waterproof performance of the acoustic device 01 can be ensured. The compression ratio of the buffer member 220 may be described according to an Equation:

$$\text{(Original thickness-Compressed thickness)/Original thickness} \times 100\%.$$

For example, the original thickness of the buffer member 220 is first recorded. When the buffer member 220 is pressed down, the compressed thickness of the buffer member 220 is recorded, thereby obtaining the compression ratio of the buffer member 220. The preset value may depend on a material of the buffer member 220. For example, when the buffer member 220 is the foam adhesive, the preset value of the compression ratio may be 30%, thereby ensuring that the foam adhesive has the relatively good sealing and bonding properties.

Since a weight of the acoustic assembly 30 is relatively light, the compression ratio of the buffer member 220 may be less than the above-described preset value when the acoustic assembly 30 is placed on the waterproof assembly 20. Accordingly, in some embodiments, to make the compression ratio of the buffer member 220 to reach the above-described preset value, a heavy object may be placed on the acoustic assembly 30. For example, the heavy object is placed on the circuit board 320. A gravity of the heavy weight causes the circuit board 320 to press down the buffer member 220, so that the compression ratio remains above the preset value.

Therefore, by causing the head portion 412 of each fixing member 410 to abut against the circuit board 320 along the first direction F1, the acoustic assembly 30 and the waterproof assembly 20 can be fixed in the internal space, and the pressure can also be applied on the circuit board 320 to press down the buffer member 220, thereby causing the compression ratio to remain above the preset value, ensuring that the foam adhesive has the good sealing and bonding properties, and ensuring the waterproofing capability of the acoustic device 01.

In some embodiments, the reinforcing member 330 includes at least one second fixing hole 331. The rod portion 411 of each fixing member 410 passes through one second fixing hole 331 corresponding to the fixing member 410. As shown in FIG. 5B, the reinforcing member 330 is located between the circuit board 320 and the waterproof assembly 20. The second fixing holes 331 and the first fixing holes 321 on the reinforcing member 330 may correspond one by one. That is, the rod portion 411 passes through the first fixing holes 321 and the second fixing holes 331 sequentially. In some embodiments, the reinforcing member 330 is provided with an additional second fixing hole 331 in a portion that is not covered by the circuit board 320, in addition to the second fixing hole 331 corresponding to the first fixing hole 321. By providing the additional second fixing holes 331 on the reinforcing member 330 and fixing the reinforcing member 330 by the fixing member 410, the acoustic assembly 30 and the waterproof assembly 20 are fixed more firmly in the internal space.

In some embodiments, the circuit board 320 is provided without fixing holes so as not to interfere with a routing of wiring in the circuit board 330. As shown in FIG. 5C, the reinforcing member 330 is provided with at least one third fixing hole 332, and the fixing assembly 40 includes at least one fixing member 410. The at least one fixing member 410 and the at least one third fixing hole 332 are matched in a one-to-one corresponding manner, thereby fixing the acoustic assembly 30.

The at least one fixing member 410 may be distributed around the accommodation cavity 130. In some embodiments, the at least one fixing member 410 may include a plurality of fixing members 410, and the present disclosure does not limit counts of the fixing member 410, the first fixing hole 321, the second fixing hole 331, and the third fixing hole 332. In some embodiments, the plurality of fixing members 410 surround the acoustic assembly 30 in various directions, thereby fixing the acoustic assembly 30 in the plurality of directions. In some embodiments, when there are a plurality of fixing members 410, the plurality of fixing members 410 are ununiformly distributed around the accommodation cavity 130 to improve a fixation of specific positions or specific components of the acoustic assembly 30. In some embodiments, when there are a plurality of fixing members 410, the plurality of fixing members 410 are uniformly, or substantially uniformly, distributed around the accommodation cavity 130, so that the acoustic assembly 30 is subjected to a uniform pressure, thereby causing the buffer members 220 to be compressed uniformly. As shown in FIG. 4, three fixing members 410 are disposed on the housing 10, and three third fixing holes 332 are opened on the reinforcing member 330. The three third fixing holes 332 are distributed in a triangular shape around the accommodation cavity 130, so that the acoustic assembly 30 is firmly fixed while the acoustic assembly 30 is subjected to a relatively uniform pressure. In some embodiments, the housing 10 is provided with four fixing members 410, and the reinforcing member 330 is provided with four third fixing holes 332. The four third fixing holes 332 and the four fixing members 410 may be arranged in a rectangular shape around the accommodation cavity 130, so that the acoustic assembly 30 is subjected to the relatively uniform pressure while ensuring that the reinforcing member 330 is pressed down at various places, thereby ensuring that the reinforcing member 330 is not easy to warp.

In some embodiments, the above-described fixing members 410 may be screws. When the fixing members 410 are screws, the inner wall 110 of the fixing hole may be provided with patterns each of which matches a thread of one of the screws. The acoustic assembly 30 and the waterproof assembly 20 may be fixed in the internal space of the housing 10 by tightening the screws. The head portion 412 of the tightened screw abuts against the circuit board 320 along the first direction F1, so that the circuit board 320 presses down the buffer members 220. In some embodiments, the rod portion 411 and the head portion 412 of the fixing member 410 may be connected through a clamping groove and a clamping fastener. After the circuit board 320 or the reinforcing member 330 is placed, the head portion 412 is clamped to the rod portion 411 through the clamping groove and the clamping fastener.

In some embodiments, the above-described fixing member 410 may be a heat stake 410'. The fixing member 410 may be formed by a heat staking material, such as a plastic member. When the circuit board 320 is the FPC, the circuit board 320 is not easy to punch holes directly and contact the heat staking material (with a relatively high temperature) due to its relatively high flexibility and a dense distribution of the circuits on the circuit board 320. Therefore, when the fixing member 410 is the heat stake 410', the above-described solution where the third fixing hole 332 is disposed in the reinforcing member 330 may be used.

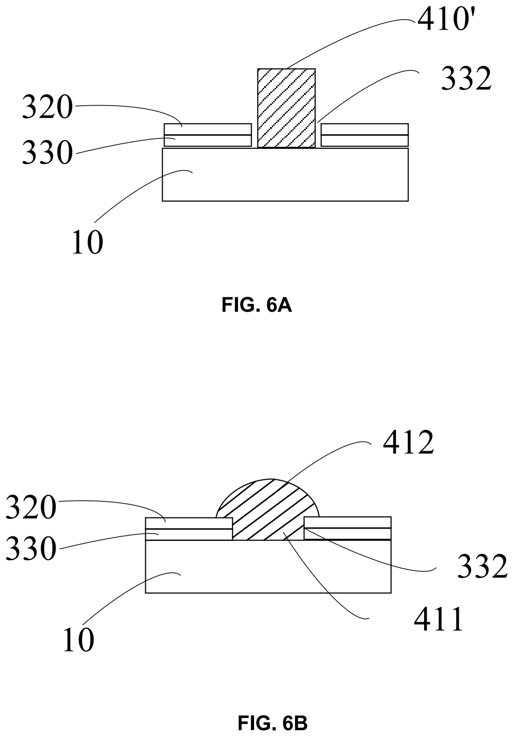

FIG. 6A is a schematic diagram illustrating a shape of a heat stake 410' before heat staking according to some embodiments of the present disclosure. FIG. 6B is a schematic diagram illustrating a shape of the heat stake 410' shown in FIG. 6A after the heat staking according to some embodiments of the present disclosure. The heat stake 410' is illustrated by a shaded portion.

As shown in FIG. 6A, before being heat staked, the heat stake 410' is a column that passes through the third fixing hole 332, and there is a gap between the heat stake 410', the circuit board 320, and the reinforcing member 330. The heat stake 410' may be a solid heat stake 4, a ribbed heat stake, a hollow heat stake, etc., which is not limited in the present disclosure. The heat stake 410' may be fused and then molded by heating. A manner of heating the heat stake 410' may be a hot air heat staking, a pulse heat staking, an ultrasonic heat staking, etc., which is not limited in the present disclosure.

As shown in FIG. 6B, the molded heat stake 410' may include the rod portion 411 and the head portion 412 as described above. The head portion 412 is formed by the deformation of the above-described heat stake 410' after a top portion of the heat stake 410' is heat staked. The rod portion 411 is threaded through the corresponding third fixing hole 332, and the head portion 412 abuts against an upper surface of the circuit board 320, thereby fixing the circuit board 320 to the top surface of the accommodation sidewall 131 and pressing the waterproof assembly 20 (the buffer members 220).

By using the heat staked compression, a rivet-like structure is formed by the originally columnar heat stake 410', thereby pressing down the buffer members 220 and fixing the acoustic assembly 30 to the housing 10. This operation is simple and efficient, and the heat staked material also seals the gap between the fixing member 410 and the third fixing hole 332 at the same time. Therefore, there is no need to seal the gap between the fixing member 410 and the third fixing hole 332 again, thereby simplifying the operation, improving the efficiency, and reducing the costs.

It is worth noting that, a height at which the heat stake 410' after the heat staking presses down the waterproof assembly 20 relates to a mass of a portion of the heat stake 410' that is heat staked. The greater the mass of the heat staked portion, the greater the mass of the head portion 412 pressing down the circuit board 320, and the greater a compression amount of the waterproof assembly 20. The mass of the heat staked portion is positively correlated with the height of the heat stake 410'. Thus, the height at which the heat stake 410' after the heat staking presses down the waterproof assembly 20 relates to the height of the heat staked portion of the heat stake 410'. The higher the height of the heat staked portion, the greater the mass of the head portion 412 that presses down the circuit board 320, and the greater the compression amount of the waterproof assembly 20. It should be noted that a compression degree of the buffer member 220 should not be too great, and it is desirable to leave a sound transmission region of the waterproof membrane 210 in a powerless free state. In some embodiments, the waterproof membrane 210 being in a powerless free state is described through a height of each of stack layers of the waterproof assembly 20 before compression and a height of the stack layer after the compression.

As previously described, the waterproof assembly 20 may include the buffer members 220, the waterproof membrane 210, the support members, and the bonding layers. For explaining when the waterproof membrane 210 is in the free state, an uncompressed waterproof membrane 210 is taken as an example. The uncompressed waterproof membrane 210 successively includes a buffer member 220 (with a thickness of A1 mm), a support member (with a thickness of B1 mm), a bonding layer (with a thickness of C1 mm), a waterproof membrane 210 (with a thickness of D mm), a bonding layer (with a thickness of C2 mm), a support member (with a thickness of B2 mm), and a buffer member 220 (with a thickness of A2 mm), and a total thickness of the waterproof assembly 20 is T1. Under a premise of ensuring that the waterproof assembly 20 is compressed and not laterally deformed, a compression ratio of the buffer members is within a range from 45% to 55%, and a compression ratio of the bonding layers is within a range from 15% to 25%. The thickness of each layer after compression is the buffer member 220 (within a thickness range from 0.45A1 to 0.55A1 mm), the support member (with the thickness of B1 mm), the bonding layer (within a thickness range from 0.15C1 to 0.25C1 mm), the waterproof membrane 210 (with the thickness of D mm), the bonding layer (within a thickness range from 0.15C2 to 0.25C2 mm), the support member (with the thickness of B2 mm), the buffer member 220 (within a thickness range from 0.45A2 to 0.55A2 mm), and the total thickness of the waterproof assembly 20 is T2 mm. T2 is smaller than T1. Considering a manufacturing precision of the housing 10, the total thickness of the compressed waterproof assembly 20 may also be reserved with a certain margin. After the waterproof assembly 20 is pressed and fixed in this way, a gel (the bonding layers and the buffer members) is in a compressed state, but is only compressed in a height direction, and no deformation is in the lateral direction. At this time, the waterproof membrane 210 is subjected to a negligible force in the lateral direction. Therefore, the sound transmission region of the center hole 221 within a diameter range from 0.8 mm to 1.8 mm relative to the waterproof membrane 210 is substantially in the powerless free state, thereby embodying the optimal effect with best consistency.

As there are manufacturing errors in the height, the shape, etc., of the heat stake 410', the deformation degree of the waterproof assembly 20 is controlled only by controlling the mass of the heat stake 410', which is not easy to ensure an accurate deformation of the waterproof assembly 20. Therefore, the height of the accommodation cavity 130 can be reasonably designed to control the deformation degree of the waterproof assembly 20. As previously described, the waterproof assembly 20 is located within the accommodation cavity 130. Therefore, the amount of compression required for the waterproof assembly 20 may be determined based on a difference between the total height of the acoustic member 30 and the waterproof assembly 20 after assembly in the uncompressed state and the total height of the acoustic member 30 and the waterproof assembly 20 after the assembly in an ideal compressed state. Then the height of the accommodation cavity 130 is reasonably designed, so that the upper surface of the buffer member 220 in the waterproof assembly 20 in the uncompressed state is higher than the inner wall 110 of the housing by a preset distance. That is, in the uncompressed state, the upper surface of the buffer member 220 is spaced apart from the inner wall 110 of the housing with the preset distance. The preset distance may be the amount of compression of the waterproof assembly 20 that is required by the design. The amount of compression of the waterproof assembly 20 may be an amount of compression that the buffer member 220 is required to undergo, or an amount of compression of all of the components in the waterproof assembly 20 that can be compressed. In this way, only by designing the height of the heat stake 410', the force applied by the heat stake 410' after the heat staking on the circuit board 320/the reinforcing member 330 is precisely sufficient to abut the reinforcing member 330 against an edge of the accommodating cavity 130, so that the waterproof assembly 20 is compressed to a target state. This manner is easy to operate and has high accuracy, thereby improving the efficiency and reducing the costs. In some embodiments, when the depth of the accommodation cavity 130 is 0.35 mm, the height of the heat stake 410' before the heat staking is within a range from 0.6 mm to 1 mm, which allows the heat stake 410' after the heat staking to abut the reinforcing member 330 against the edge of the accommodating cavity 130 and leave the waterproof membrane 210 in the powerless free state.

In some embodiments, after the waterproof assembly 20 and the acoustic assembly 30 are fixed within the housing 10, surfaces of the assemblies may then be sealed with the sealant. By using the sealant, the waterproof assembly 20 and the acoustic assembly 30 may be more firmly fixed within the housing 10, thereby preventing the heat stake 410' from falling off during a long-term use which causes a state of the waterproof membrane 210 to change and affects the acoustic and waterproofing performances. In addition, an airtightness can be ensured, thereby ensuring the airtightness between the interior and exterior of the earphone housing 10. Further, the gap between the waterproof assembly 20 and the accommodating sidewall 131 can be filled to prevent the water from entering from the various layers of the waterproof assembly 20 close to the sidewall and prevent causing a waterproofing failure. In some embodiments, the sealant may be a UV adhesive, a silicone adhesive, a thermal fusion adhesive, etc.

In summary, after reading the present disclosure, those skilled in the art may understand that the foregoing detailed disclosure is presented by way of example only and may not be limiting. While not expressly stated herein, those skilled in the art may understand that the present disclosure is intended to encompass a variety of reasonable changes, improvements, and modifications to the embodiments. These changes, improvements, and modifications are intended to be made by this application and are within the spirit and scope of the exemplary embodiments of the present disclosure.

In addition, certain terminology in the present disclosure are used to describe embodiments of the present disclosure. For example, "an embodiment," "embodiments," and/or "some embodiments" means that a particular feature, structure, or characteristic described in conjunction with the embodiment may be included in at least one embodiment of the present disclosure. Accordingly, it may be emphasized and understood that the terms "embodiment" or "an embodiment" or "some embodiments" in various parts of the present disclosure do not necessarily all refer to the same embodiment. In addition, particular features, structures, or characteristics may be suitably combined in one or more embodiments of the present disclosure.

It should be appreciated that in the foregoing descriptions of embodiments of the present disclosure, to aid in the understanding of a feature, and for the purpose of simplification of the present disclosure, the present disclosure sometimes combines features in a single embodiment, the accompanying drawing, or the description thereof. Alternatively, the present disclosure again scatters various features across multiple embodiments of the present disclosure. However, this does not mean that the combination of these features is necessary, and it is entirely possible that those skilled in the art could extract some of these features as separate embodiments to be understood when reading the present disclosure. That is to say, embodiments in the present disclosure may also be understood as an integration of a plurality of sub-embodiments. And this also holds true when each of the sub-embodiments lies in fewer than all of the features of a single previously disclosed embodiment.

In some embodiments, numbers expressing quantities or properties used to describe and claim certain embodiments of the present disclosure may be understood as modified in some cases by the terms "about," "approximately," or "substantially." For example, unless otherwise noted, the terms "about," "proximate" or "substantially" may be used to indicate a ±20% variation in the value it describes, unless otherwise stated. Accordingly, in some embodiments, the numerical parameters set forth in the written description and the appended claims are approximations, which vary depending on the desired properties sought to be obtained by a particular embodiment. In some embodiments, the numerical parameters are to be interpreted based on the quantity of valid numbers reported and by applying common rounding techniques. While some embodiments elaborating on the present disclosure list a wide range of numerical ranges and parameters that are approximations, specific embodiments are listed with values that are as precise as possible.

Each patent, patent application, publication of a patent application, and other material cited herein, such as articles, books, specifications, publications, documents, articles, etc., may be incorporated herein by reference. The entire contents hereof are hereby incorporated by reference for all purposes, except any prosecution document history related thereto, any similar prosecution document history that may be inconsistent or conflicting with this document, or any similar prosecution document history that may have a limiting effect on the broadest scope of the claims. Now or hereafter associated with this document For example, in the event of any inconsistency or conflict between the descriptions, definitions and/or use of terms associated with any of the included materials in connection with this document, the use of the terms in the present disclosure shall prevail.

Finally, it should be understood that the embodiments of the present disclosure disclosed herein are illustrations of the principles of the embodiments thereof. Other modified embodiments are also within the scope of the present disclosure. The embodiments disclosed in the present disclosure are therefore intended to be exemplary only and not limiting. Those skilled in the art may adopt alternative configurations based on the embodiments in the present disclosure to realize the application in the present disclosure. As such, embodiments of the present disclosure are not limited to those embodiments that are precisely described in the present disclosure.

**Claims**

1.  An acoustic device, comprising

    a housing including an outer wall, an inner wall, an accommodation cavity, and a sound connection hole, wherein the sound connection hole opens into the accommodation cavity and penetrates through the housing for connecting the accommodation cavity to an external space of the housing, and the sound connection hole includes a first opening on the outer wall and a second opening on the inner wall;
    a waterproof assembly disposed within the accommodation cavity and covering the sound connection hole to prevent liquid from entering an internal space of the housing from the external space of the housing;
    an acoustic assembly including an acoustic transducer, wherein the acoustic assembly is disposed on a side of the waterproof assembly away from the sound connection hole and forms a first gap with the inner wall;
    a fixing assembly disposed on the inner wall for fixing the acoustic assembly and the waterproof assembly in the internal space; and
    a sealing member configured to seal the first gap.

2.  The acoustic device of claim 1, wherein

    the acoustic assembly further includes a circuit board, wherein the circuit board is provided with at least one first fixing hole and mechanically connected to the acoustic transducer; and
    the fixing assembly includes at least one fixing member, wherein each of the at least one fixing member cooperates with one of the at least one first fixing hole.

3.  The acoustic device of claim 2, wherein for each of the at least one fixing member,

    the fixing member includes a rod portion and a head portion, a first end of the rod portion is connected to the inner wall, and a second end of the rod portion is connected to the head portion;
    the rod portion of the fixing member passes through the corresponding first fixing hole, and the head portion of the fixing member abuts against the circuit board along a first direction to fix the acoustic assembly and the waterproof assembly in the internal space, wherein the first direction is perpendicular to an upper surface of the circuit board.

4. The acoustic device of claim 3, wherein the acoustic assembly further includes a reinforcing member, the reinforcing member is disposed between the circuit board and the waterproof assembly, and the reinforcing member includes at least one second fixing hole; and
the rod portion of each of the at least one fixing member passes through one second fixing hole among the at least one second fixing hole.

5. The acoustic device of claim 1, wherein the acoustic assembly further includes a circuit board and a reinforcing member, the reinforcing member is disposed between the waterproof assembly and the circuit board, and mechanically connected to the circuit board; and
the reinforcing member is provided with at least one third fixing hole, the fixing assembly includes at least one fixing member, and each of the at least one fixing member cooperates with one of the at least one third fixing hole.

6. The acoustic device of claim 4 or 5, wherein the circuit board is a flexible circuit board;
the reinforcing member is in a form of a plate, and a stiffness of the reinforcing member is greater than a stiffness of the circuit board.

7. The acoustic device of claim 4 or 5, wherein the inner wall is a curved surface,

the inner wall further includes an assembly groove, the accommodation cavity is disposed in the assembly groove, a bottom surface of the assembly groove is a plane,
at least a portion of the circuit board is mounted within the assembly groove and abuts against the bottom surface of the assembly groove,
a shape of the assembly groove matches the circuit board or the reinforcing member to restrict a movement of the acoustic assembly in an extension direction of a board surface of the circuit board.

8. The acoustic device of any one of claims 2-5, wherein the at least one fixing member includes a screw and/or a heat stake; and
the at least one fixing member is distributed around the accommodation cavity.

9. The acoustic device of any one of claims 1-5, wherein a thickness of the waterproof assembly in a free state is larger than a depth of the accommodation cavity.

10. The acoustic device of claim 9, wherein the waterproof assembly includes:

a waterproof membrane; and
a buffer member provided with a center hole, the buffer member abutting against an edge region of the waterproof membrane.

11. The acoustic device of claim 10, wherein

the waterproof assembly has a first bonding surface and a second bonding surface;
the first bonding surface includes an adhesive configured to bond the waterproof assembly to an accommodation bottom wall of the accommodation cavity when external pressure is applied to the first bonding surface; and
the second bonding surface includes an adhesive configured to bond the waterproof assembly to the acoustic assembly when the second bonding surface contacts the acoustic assembly.

12. The acoustic device of claim 1, wherein the acoustic device is an earphone, and the acoustic transducer is a microphone and/or a speaker.

13. The acoustic device of claim 1, wherein the sealing member is obtained by providing a fluid sealing material to the first gap and then curing the fluid sealing material.

14. The acoustic device of claim 13, wherein the fluid sealing material is a sealant.

15. The acoustic device of claim 1, wherein the waterproof assembly is disposed on an accommodation bottom wall of the accommodation cavity, and a center axis of the sound connection hole is inclined relative to the accommodation bottom wall;

the second opening is smaller than the first opening; and
an average diameter of the sound connection hole is within a range from 0.6 millimeters (mm) to 1.2 mm.

16. The acoustic device of claim 1, wherein

the acoustic transducer includes a first acoustic transducer and a second acoustic transducer; and
the accommodation cavity includes a first accommodation cavity and a second accommodation cavity that accommodate the first acoustic transducer and the second acoustic transducer, respectively.

<u>**01**</u>

A          A

**FIG. 1**

**FIG. 2A**

**FIG. 2B**

**FIG. 3**

**FIG. 4**

**FIG. 5A**

**FIG. 5B**

**FIG. 5C**

410'

332

320

330

10

**FIG. 6A**

412

320

330

332

411

10

**FIG. 6B**

## INTERNATIONAL SEARCH REPORT

| International application No. |
| --- |
| **PCT/CN2023/143682** |

**A. CLASSIFICATION OF SUBJECT MATTER**

H04R1/10(2006.01)i

According to International Patent Classification (IPC) or to both national classification and IPC

**B. FIELDS SEARCHED**

Minimum documentation searched (classification system followed by classification symbols)

IPC:H04R

Documentation searched other than minimum documentation to the extent that such documents are included in the fields searched

Electronic data base consulted during the international search (name of data base and, where practicable, search terms used)

CNABS, CNTXT, EPTXT, VEN, CNKI, USTXT, IEEE: 韶音, 周文兵, 黄雨佳, 柯浩, 张恒浩, 廖风云, 齐心, 传声器, 声学传感器, 拾音器, 扬声器, 喇叭, 麦克风, 换能器, 挡水, 阻水, 防潮, 防水, 疏水, 隔水, 密封, 固定, 开口, 洞, 孔, 壳体, 螺钉, 电路板, 线路板, aperture, bore, cavity, hole, hollow, glue, bolt, mucus, pastern, manger, loudspeaker, microphone, mike, speaker, transducer, pressurize, shell, case, shuck, waterproof, airproof, breakwater, pcb, printed circuit board

**C. DOCUMENTS CONSIDERED TO BE RELEVANT**

| Category* | Citation of document, with indication, where appropriate, of the relevant passages | Relevant to claim No. |
| --- | --- | --- |
| X | CN 214335480 U (GUANGDONG OPPO MOBILE TELECOMMUNICATIONS CORP., LTD.) 01 October 2021 (2021-10-01) <br> description, paragraphs [0029]-[0103], and figures 1-12 | 1-16 |
| X | CN 217011189 U (GOERTEK INC.) 19 July 2022 (2022-07-19) <br> description, paragraphs [0031]-[0085], and figures 1-4 | 1-16 |
| A | CN 104080304 A (FUJITSU LTD.) 01 October 2014 (2014-10-01) <br> entire document | 1-16 |
| A | CN 217883759 U (ARASHI VISION INC.) 22 November 2022 (2022-11-22) <br> entire document | 1-16 |
| A | WO 2014188297 A1 (SIEMENS MEDICAL INSTRUMENTS PTE. LTD.) 27 November 2014 (2014-11-27) <br> entire document | 1-16 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **28 August 2024** | **30 August 2024** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/143682**

| Patent document cited in search report | | | Publication date (day/month/year) | Patent family member(s) | | | Publication date (day/month/year) |
|---|---|---|---|---|---|---|---|
| CN | 214335480 | U | 01 October 2021 | None | | | |
| CN | 217011189 | U | 19 July 2022 | None | | | |
| CN | 104080304 | A | 01 October 2014 | KR | 20140118726 | A | 08 October 2014 |
| | | | | KR | 101536859 | B1 | 14 July 2015 |
| | | | | US | 2014294217 | A1 | 02 October 2014 |
| | | | | US | 9843659 | B2 | 12 December 2017 |
| | | | | JP | 2014200024 | A | 23 October 2014 |
| | | | | JP | 6075163 | B2 | 08 February 2017 |
| CN | 217883759 | U | 22 November 2022 | None | | | |
| WO | 2014188297 | A1 | 27 November 2014 | DE | 102013213891 | A1 | 27 November 2014 |

Form PCT/ISA/210 (patent family annex) (July 2022)